# EUROPÄISCHE PATENTSCHRIFT

(11) **EP 4 390 747 B1**
(45) Veröffentlichungstag und Bekanntmachung des Hinweises auf die Patenterteilung: **14.10.2026**
(21) Anmeldenummer: 23211097.3
(22) Anmeldetag: 21.11.2023
(51) Int. Cl.: G06F 30/20

(54) **VERFAHREN ZUM ERSTELLEN EINER CO-SIMULATION**
METHOD FOR CREATING A CO-SIMULATION
PROCÉDÉ DE CRÉATION D'UNE COSIMULATION

(30) Priorität: 20.12.2022 DE 102022134031
(43) Veröffentlichungstag der Anmeldung: 26.06.2024
(73) Patentinhaber: dSPACE SE & Co. KG, 33102 Paderborn (DE)
(72) Erfinder: KRONMÜLLER, Martin, 33102 Paderborn (DE)

(56) Entgegenhaltungen:
- US-B1- 10 585 771
- DUPUY A ED - MACNAIR E A ET AL: "NEST: A NETWORK SIMULATION & PROTOTYPING TESTBED*", PROCEEDINGS OF THE WINTER SIMULATION CONFERENCE. WASHINGTON, DEC. 4 - 6, 1989; [PROCEEDINGS OF THE WINTER SIMULATION CONFERENCE], NEW YORK, IEEE, US, vol. -, 4 December 1989 (1989-12-04), pages 1058 - 1064, XP000207502

## Beschreibung

Die Erfindung betrifft ein Verfahren zum Erstellen einer eine Mehrzahl von Simulationsmodulen aufweisenden Co-Simulation, wobei die Simulationsmodule jeweils wenigstens eine Kommunikationsschnittstelle aufweisen und jeweils mit Simulationsagenten ausführbar sind, umfassend die folgenden Verfahrensschritte: Erzeugen von Simulationskomponenten, die jeweils ein Container für ein Simulationsmodul oder mehrere Simulationsmodule sind, Einordnen der Simulationsmodule in die Simulationskomponenten, Versehen jeder Simulationskomponente mit einem Laufzeitumgebungs-Informationsmodul, das Informationen zu Anforderungen der in der Simulationskomponente enthaltenen Simulationsmodule an die Laufzeitumgebung aufweist, wobei die jeweiligen Simulationsagenten den Anforderungen der Simulationsmodule entsprechende Eigenschaften aufweisen müssen, um diese ausführen zu können, und Versehen einer jeden Simulationskomponente mit einer Kommunikationseinheit, die eine Beschreibung der Kommunikationsschnittstelle des Simulationsmoduls enthält, sodass eine Kommunikation mit weiteren Simulationskomponenten ermöglicht wird.

Es gibt eine Vielzahl von Simulationswerkzeugen zum Erstellen von Model-in-the-loop-, Software-in-the-loop-, Hardware-in-the-loop- oder Connected-mixed-reality-Simulationen. Ein Simulationswerkzeug besteht regelmäßig aus einem Editor, mit dessen Hilfe definierbar ist, was simuliert werden soll, und einem Compiler, einem Just-in-time-Compiler oder einem Interpreter in einer Simulationsumgebung. Mit dem Compiler, dem Just-in-time-Compiler bzw. dem Interpreter ist die in dem Editor definierte Simulation ausführbar. Jedes dieser Simulationswerkzeuge ist typischerweise für spezielle Anwendungsgebiete ausgestaltet. Connected-mixed-reality-Simulationen sind dabei Mischsimulation aus echten und simulierten Steuergeräten.

Ein auf einer Recheneinheit ausgebildetes Simulationswerkzeug ist ein Simulationsagent. Die Recheneinheit muss dabei nicht zwangsläufig eine lokalisierbare Recheneinheit sein. Vielmehr kann diese Recheneinheit Teil eines Rechen-Clusters oder Teil einer Cloud-Computing-Lösung sein. Die einzelne Simulation ist ein mit dem Simulationsagenten ausgeführtes Simulationsmodul, wobei das Simulationsmodul ein in den Editor eines Simulationswerkzeuges portierbares Skript sein kann. Ein Skript ist eine Datei, die mit dem Simulationsagenten umsetzbar ist und auch im Binärformat vorliegen kann. Sollte es notwendig sein, kann vor der Ausführung eine Executable aus dem Simulationsmodul erzeugt werden. Die Executable ist ein kompiliertes Skript und somit ein auf einem Prozessor ausführbares Programm.

Eine Co-Simulation zeichnet sich dadurch aus, dass sie mehrere Simulationsmodule enthält, die verschieden ausgestaltet sein können und gleichartiger, aber auch verschiedenartiger Simulationsagenten zur Ausführung bedürfen können. Um eine Co-Simulation mit verschiedenen Simulationsmodulen und den zugehörigen Simulationsagenten zu erstellen, müssen die Simulationsmodule oder die spezifischen Simulationsumgebungen der Simulationswerkzeuge der Simulationsagenten derart modifiziert werden, dass Daten zwischen den Simulationsmodulen über spezielle Bussysteme austauschbar sind. Diese Kommunikation muss innerhalb der einzelnen Simulationswerkzeuge und somit jeweils auf unterschiedliche Art und Weise realisiert werden. Neben der Kommunikation zwischen den Simulationsmodulen soll eine konsistente Verteilung der Simulationsmodule auf die unterschiedlichen Simulationsumgebungen, eine Zeitsynchronisation und eine Steuerung der Simulationen realisiert werden.

Die US10585771B1 beschreibt ein Testsystem, mit welchem ein System, das aus unterschiedlichen Hardware-Komponenten besteht, getestet werden kann. Dabei wird ermöglicht, ggf. noch nicht vorhandene Komponenten des zu testenden Systems mittels des Testsystems in einer Co-Simulation mit den bereits vorhandenen Komponenten zu testen. Das dort beschriebene System bietet durch geeignete Schnittstellenbeschreibungen und -module sowie durch eine Schnittstellen Bibliothek die Möglichkeit, simulierte Komponenten in dem Testsystem in einfacher Weise durch die entsprechenden realen Hardware-Komponenten zu ersetzen, sobald die entsprechende Hardware vorliegt.

Die Functional Mock-up Interface-Spezifikation definiert einen Standard, der Container beschreibt, die Simulationsmodule aufnehmen können. Diese Container sind mit Schnittstellenbeschreibungen zur Kommunikation versehen. Dementsprechend ist die Kommunikation der in Simulationskomponenten eingeordneten Simulationsmodule sowie die Art der ausgetauschten Daten ausschließlich innerhalb der zugehörigen Simulationsagenten definiert und somit nicht allgemeingültig. Daraus folgt, dass die Ausführung eines Simulationsmoduls auf unterschiedlichen Simulationsagenten jeweils erneut eine Anpassung der Kommunikation erfordert und dass Änderungen der Simulation betreffend die Model-in-the-loop-, Software-in-the-loop-, Hardware-in-the-loop- oder Connected-mixed-reality-Simulationsart Kommunikationsänderungen zur Folge haben, die ihrerseits notwendige zeitintensive Anpassungen in der Kommunikation der Simulationsmodule erfordern. Jede Änderung in den Simulationsmodulen oder in der Simulationsart bedingt somit eine weitere angepasste speicherintensive Co-Simulation. Die Verteilung eines Simulationsmodells auf diverse Simulationsumgebungen muss ebenfalls spezifisch zur Simulationsumgebung erfolgen.

Davon ausgehend ist es die Aufgabe der Erfindung, ein verbessertes Verfahren zum Erstellen einer Co-Simulation bereitzustellen.

Diese Aufgabe wird durch den Gegenstand des Patentanspruchs 1 gelöst. Bevorzugte Weiterbildungen finden sich in den Unteransprüchen.

Erfindungsgemäß wird also ein Verfahren zum Erstellen einer eine Mehrzahl von Simulationsmodulen aufweisenden Co-Simulation bereitgestellt, wobei die Simulationsmodule jeweils wenigstens eine Kommunikationsschnittstelle aufweisen und jeweils mit Simulationsagenten ausführbar sind, umfassend die folgenden Verfahrensschritte:
Erzeugen von Simulationskomponenten, die jeweils ein Container für ein Simulationsmodul oder mehrere Simulationsmodule sind,
Einordnen der Simulationsmodule in die Simulationskomponenten,
Versehen jeder Simulationskomponente mit einem Laufzeitumgebungs-Informationsmodul, das Informationen zu Anforderungen der in der Simulationskomponente enthaltenen Simulationsmodule an die Laufzeitumgebung aufweist, wobei die jeweiligen Simulationsagenten den Anforderungen der Simulationsmodule entsprechende Eigenschaften aufweisen müssen, um diese ausführen zu können,
Versehen einer jeden Simulationskomponente mit einer Kommunikationseinheit, die eine Beschreibung der Kommunikationsschnittstelle des Simulationsmoduls enthält, sodass eine Kommunikation mit weiteren Simulationskomponenten ermöglicht wird,
Verbinden der Kommunikationseinheiten der Simulationskomponenten mit einer oder mehreren Kommunikationseinheiten weiterer Simulationskomponenten, sodass ein Netzwerk der über die Kommunikationseinheiten miteinander verbundenen Simulationskomponenten gebildet wird, wobei dieses Netzwerk aus Simulationskomponenten eine Simulationskomponentenebene bildet, die unabhängig von den physischen Anforderungen an die Laufzeitumgebung ist, die Informationen zu den Anforderungen zur Ausführung der Simulationskomponentenebene jedoch in den Laufzeitumgebungs-Informationsmodulen enthalten sind, und
Erstellen einer Co-Simulationsanwendung, in der die Simulationskomponenten der Simulationskomponentenebene einem Simulationsagententypen mit den Laufzeitumgebungs-Informationsmodulen der Simulationskomponenten zugeordnet werden, wobei der Simulationsagententyp eine Beschreibung der Eigenschaften des zur Ausführung des Simulationsmoduls benötigten Simulationsagenten ist.

Damit wird ein Verfahren zum Erstellen einer Co-Simulation bereitgestellt, das wesentlich zeit- und speichereffizienter als herkömmliche Verfahren ist. Mit der Erfindung kann somit durch die Verbesserung computerinterner Prozesse die vorhandene Computer-Hardware wesentlich effizienter genutzt werden als bisher.

Die kleinste Einheit einer Co-Simulation ist das einzelne Simulationsmodul. Jedes Simulationsmodul hat Anforderungen an seine Laufzeitumgebung. Ein für die Co-Simulation verwendbares Simulationswerkzeug ist insofern Teil dieser Anforderungen. Die Anforderungen können darüber hinaus jedenfalls auch noch die Prozessorarchitektur, die Anzahl verfügbarer CPUs und GPUs, den Arbeitsspeicher oder das Betriebssystem betreffen. Das Simulationswerkzeug ist neben den weiteren Anforderungen als Eigenschaft auf einem Simulationsagenten ausgebildet, der das Simulationsmodul ausführen kann.

Das Simulationsmodul ist in einer Simulationskomponente eingeordnet, die mit einer Kommunikationseinheit und einem Laufzeitumgebungs-Informationsmodul versehen ist. Die Kommunikationseinheit enthält eine Beschreibung der Kommunikationsschnittstelle des Simulationsmoduls. Dadurch ist die Art der Kommunikation mit weiteren Simulationskomponenten definierbar. Die in der Kommunikationsschnittstelle möglichen Kommunikationsarten sind unabhängig von spezifischen Simulationsagenten und können eine signalbasierte Kommunikation in Form von Modelport-Verbindungen oder eine BusAccess-Request in Form eines automotiven Busses wie Ethernet, CAN, Lin oder FlexRay sein. Der physikalische Bus muss nicht zwangsläufig in jeder Simulationskomponente bereitgestellt werden. Vielmehr kann der physikalische Bus für eine Simulationskomponente von einer anderen Simulationskomponente bereitgestellt werden. Im Kontext einer Software-in-the-loop-Simulationsart ist daher nicht zwangsläufig ein physikalischer Bus notwendig. Eine direkte Kommunikation mit einer weiteren Simulationskomponente kann vielmehr auch mit einem virtuellen Bus etabliert werden. Darüber hinaus kann der Datenaustausch über eine globale Datenstruktur, die zwischen den Simulationsagenten synchronisiert wird, sowie über Ein- und Ausgänge in Form von elektrischen Signalen ermöglicht werden, die die Simulationskomponenten miteinander verbinden.

Die Laufzeitumgebungs-Informationsmodule der Simulationskomponenten zeigen die zur Ausführung des Simulationsmoduls benötigten Anforderungen an die Laufzeitumgebung an. Die Anforderungen an die Laufzeitumgebung beinhalten die Anforderungen, die ein Simulationsagent als Eigenschaften mindestens aufweisen muss, um die entsprechende Simulationskomponente ausführen zu können. Dazu gehören ebenfalls erforderliche Verbindungen mit anderen Simulationsagenten, in voneinander abhängigen, oder Simulationskomponenten, die einander bedingen.

Mit dem Bilden einer Co-Simulationsanwendung wird eine Hierarchie erzeugt, mit der die Co-Simulationsanwendung orchestrierbar ist. Orchestrieren einer Co-Simulationsanwendung meint hier konkret das Ausführen bestimmter in den Simulationskomponenten enthaltener Simulationsmodule in einer bestimmten Reihenfolge.

Gemäß einer bevorzugten Weiterbildung der Erfindung ist vorgesehen, dass die Simulationsagenten dazu eingerichtet sind, Hardware-in-the-loop-, Software-in-the-loop- oder Model-in-the-loop-Simulationen ausführen zu können. Der Verbund an Simulationskomponenten bildet die Simulationskomponentenebene. Diese ist unabhängig von der späteren Ausführung der Co-Simulationsanwendung und insbesondere der Simulationsart. Model-in-the-loop, Software-in-the-loop, Hardware-in-the-loop- oder Connected-mixed-reality-Simulationen können auf diese Weise mit der gleichen, unveränderten Simulationskomponentenebene ausgeführt werden. Versions-Updates der Simulationskomponentenebene oder der Simulationsagenten sind unabhängig voneinander durchführbar und nehmen keinen Einfluss auf die jeweils andere Struktur.

Gemäß einer weiteren bevorzugten Weiterbildung der Erfindung umfasst das Verfahren die folgenden weiteren Verfahrensschritte: Gruppieren von Simulationskomponenten mit kompatible Anforderungen aufweisenden Laufzeitumgebungs-Informationsmodulen, Kategorisieren der Simulationskomponenten mit kompatible Anforderungen aufweisenden Laufzeitumgebungs-Informationsmodulen in eine Verarbeitungseinheitsanwendung, sodass Simulationskomponenten mit kompatible Anforderungen aufweisenden Laufzeitumgebungs-Informationsmodulen in einer gemeinsamen Verarbeitungseinheitsanwendung angeordnet sind und Simulationskomponenten mit zueinander inkompatible Anforderungen aufweisenden Laufzeitumgebungs-Informationsmodulen in verschiedenen Verarbeitungseinheitsanwendung angeordnet sind. Simulationskomponenten mit kompatiblen Anforderungen in den Laufzeitumgebungs-Informationsmodulen sind zusammen mit einem die entsprechende Beschreibung der Eigenschaften aufweisenden Simulationsagententypen ausführbar. Die Ausführung kann dabei chronologisch, parallel und unter Echtzeitbedingungen erfolgen. Es ist nicht notwendig, dass die Laufzeitumgebungs-Informationsmodule der Simulationskomponenten die gleiche Anzahl identischer bzw. kompatibler Anforderungen an die Laufzeitumgebung aufweisen. Gegebenenfalls reicht es aus, dass die Anforderungen an die Laufzeitumgebung der Simulationskomponente, die die meisten Anforderungen hat, erfüllt sind.

In einer weiteren bevorzugten Ausführungsform der Erfindung umfasst das Verfahren die folgenden weiteren Schritte: Bilden eines Simulationsinventars, das die in einem Simulationsagententypen-Netzwerk verfügbaren Simulationsagententypen enthält, und Auswählen der für die Ausführung der Verarbeitungseinheitsanwendung benötigten Simulationsagententypen aus dem Simulationsinventar. Die verfügbaren Simulationsagententypen sind diejenigen Simulationsagententypen, die für die Ausführung der Co-Simulationsanwendung zur Verfügung stehen. Die Netzwerkverbindungen der Simulationsagententypen beschreiben die Verbindungen der durch die jeweiligen Simulationsagententypen beschriebenen Simulationsagenten untereinander, sodass jegliche Kommunikation zwischen den Simulationskomponenten auf unterschiedlichen Simulationsagenten erfüllbar ist. Beispielsweise wird der Austausch von Daten über eine zwischen den Simulationsagenten synchronisierbare globale Datenstruktur ermöglicht. Ein Simulationsagententyp ist die Beschreibung der Eigenschaften des zur Ausführung des Simulationsmoduls benötigten Simulationsagenten. Es kann mehrere Simulationsagenten eines Simulationsagententyps in einem Simulationsagententypen-Netzwerk geben.

Prinzipiell können die Simulationsagenten auf verschiedene Arten mit der Co-Simulationsanwendung assoziiert werden. Gemäß einem bevorzugten Ausführungsbeispiel der Erfindung ist jedoch vorgesehen, dass das Verfahren die folgenden weiteren Schritte umfasst: Bereitstellen eines Simulationsagenteninventars, das die den Simulationsagententypen entsprechenden Simulationsagenten enthält, und Assoziieren der Co-Simulationsanwendung mit den Simulationsagenten. Das Bereitstellen eines Simulationsagenteninventars ermöglicht eine schnellere Abrufbarkeit der verfügbaren Simulationsagenten. Das Assoziieren der Co-Simulationsanwendung mit den Simulationsagenten beinhaltet das Zuweisen der Simulationsagenten zu den jeweiligen Simulationskomponenten. Die Simulationskomponenten können dann mit den entsprechenden Simulationsagenten ausgeführt werden.

Grundsätzlich kann die Co-Simulationsanwendung auf verschiedene Arten ausgeführt werden. Gemäß einem bevorzugten Ausführungsbeispiel ist jedoch vorgesehen, dass die Co-Simulationsanwendung auf einem Rechen-Cluster parallelisiert ausgeführt wird. Mehrere Instanzen dieser Co-Simulationsanwendung sind dadurch parallelisiert auf dem Rechen-Cluster ausführbar. Dabei muss nicht zwangsläufig die gesamte Co-Simulationsanwendung auf einem Rechen-Cluster ausgeführt werden. Bei Co-Simulationsanwendungen, die Hardware-in-the-loop-Simulationen ausführen, wird die Co-Simulationsanwendung gegebenenfalls nur teilweise auf einem Rechen-Cluster ausgeführt. Der Teil der Co-Simulationsanwendung, der die Hardware betrifft, kann dann auf einer spezialisierten Workstation mit der entsprechenden verknüpften Hardware ausgeführt werden. Eine Workstation meint hierbei eine lokalen Recheneinheit. Die Hardware zusammen mit der Recheneinheit sind in diesem konkreten Beispiel der Simulationsagent.

Gemäß einer bevorzugten Weiterbildung der Erfindung ist vorgesehen, dass die Co-Simulationsanwendung auf einer GPU-Architektur des Rechen-Clusters parallelisiert ausgeführt wird. Die Ausführung der Co-Simulationsanwendung auf einer GPU-Architektur ermöglicht eine besonders schnelle und effiziente Berechnung. Eine weitere bevorzugte Ausführungsform der Erfindung sieht vor, dass mehrere Instanzen von der Co-Simulationsanwendung erzeugt werden. Bei einer Mehrzahl verfügbarer Simulationsagenten der zur Ausführung der Co-Simulationsanwendung benötigten Simulationsagententypen kann so eine bessere Auslastung und somit eine effizientere Nutzung der Hardware erzielt werden. Die Instanzen der Co-Simulationsanwendung können auf verschiedene verfügbare Simulationsagenten distribuiert werden und weitere Co-Simulationsanwendungen können so ebenfalls dynamisch allokierbar sein. Das ermöglicht die Priorisierung einzelner Teile der Co-Simulationsanwendung oder weiterer Co-Simulationsanwendungen.

Es ist möglich, dass die Simulationsagenten auf einer lokalen Recheneinheit ausgebildet sind. Gemäß einem bevorzugten Ausführungsbeispiel ist jedoch vorgesehen, dass die Simulationsagenten Teil eines Cloud-Computing-Systems sind und die Co-Simulationsanwendung auf dieses Cloud-Computing-System portiert wird. Teile der Co-Simulationsanwendung, die nicht Hardware-gebunden sind, können dezentralisiert in einer Cloud-Computing-Umgebung ausgeführt werden, sodass die Ausführbarkeit der Co-Simulationsanwendung nicht an die Ressourcen eines Anwenders gebunden ist und auch als Dienst zur Verfügung gestellt werden kann.

Erfindungsgemäß ist weiter ein nichtflüchtiges, computerlesbares Speichermedium mit darauf abgespeicherten Befehlen vorgesehen, die bei ihrer Ausführung auf einem Prozessor ein Verfahren nach einem der vorhergehenden Ansprüche bewirken.

In der Zeichnung zeigen
- Fig. 1: ein Ablaufdiagramm für ein Verfahren gemäß einem bevorzugten Ausführungsbeispiel der Erfindung,
- Fig. 2: schematisch eine Simulationskomponente gemäß einem bevorzugten Ausführungsbeispiel der Erfindung und
- Fig. 3: schematisch eine Co-Simulation gemäß einem bevorzugten Ausführungsbeispiel der Erfindung.

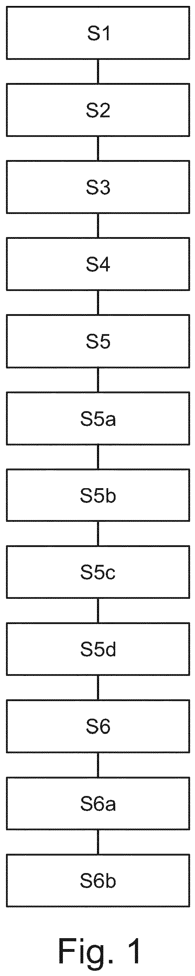

Die Fig. 1 zeigt ein Ablaufdiagramm für ein Verfahren gemäß einem bevorzugten Ausführungsbeispiel der Erfindung. Dieses Verfahren umfasst die Schritte S1 bis S6b.

Dieses Verfahren zum Erstellen einer Co-Simulation 100 mit einer Mehrzahl von Simulationsmodulen 1 mit Kommunikationsschnittstellen 2, wobei die Simulationsmodule 1 mit Simulationsagenten 4 ausführbar sind, umfasst die folgenden Schritte:
S1) Erzeugen von Simulationskomponenten 6, die Container für ein oder mehrere Simulationsmodule sind,
S2) Einordnen der Simulationsmodule 1 in die Simulationskomponenten 6,
S3) Versehen jeder Simulationskomponente 6 mit einem Laufzeitumgebungs-Informationsmodul 8, das Informationen zu den Anforderungen der in der Simulationskomponente 6 enthaltenen Simulationsmodule 1 an die Laufzeitumgebung aufweist, wobei die jeweiligen Simulationsagenten 4 den Anforderungen der Simulationsmodule 1 entsprechende Eigenschaften aufweisen müssen, um diese ausführen zu können,
S4) Versehen einer jeden Simulationskomponente 6 mit einer Kommunikationseinheit 10, die eine Beschreibung der Kommunikationsschnittstelle 2 des Simulationsmoduls 1 enthält, sodass eine Kommunikation mit weiteren Simulationskomponenten 6 ermöglicht wird,
S5) Verbinden der Kommunikationseinheiten 10 der Simulationskomponenten 6 mit einer oder mehreren Kommunikationseinheiten 10 weiterer Simulationskomponenten 6, sodass ein Netzwerk der über die Kommunikationseinheiten 10 miteinander verbundenen Simulationskomponenten 6 gebildet wird, wobei dieses Netzwerk aus Simulationskomponenten 6 eine Simulationskomponentenebene 12 bildet, die unabhängig von den physischen Anforderung an die Laufzeitumgebung ist, die Informationen zu den Anforderungen zur Ausführung der Simulationskomponentenebene 12 jedoch in den Laufzeitumgebungs-Informationsmodulen 8 enthalten sind,
S5a) Gruppieren von Simulationskomponenten 6 mit kompatiblen Anforderungen aufweisenden Laufzeitumgebungs-Informationsmodulen 8,
S5b) Kategorisieren der Simulationskomponenten 6 mit kompatiblen Anforderungen aufweisenden Laufzeitumgebungs-Informationsmodulen 8 in eine Verarbeitungseinheitsanwendung 14, sodass Simulationskomponenten 6 mit kompatiblen Anforderungen aufweisenden Laufzeitumgebungs-Informationsmodulen 8 in einer Verarbeitungseinheitsanwendung 14 angeordnet sind und Simulationskomponenten 6 mit zueinander inkompatiblen Anforderungen aufweisenden Laufzeitumgebungs-Informationsmodulen 8 in verschiedenen Verarbeitungseinheitsanwendung 14 angeordnet sind,
S5c) Bilden eines Simulationsinventars, dass die in einem Simulationsagententypen-Netzwerk verfügbaren Simulationsagententypen 16 enthält,
S5d) Auswählen der für die Ausführung der Verarbeitungseinheitsanwendung 14 benötigten Simulationsagententypen 16 aus dem Simulationsinventar,
S6) Erstellen der Co-Simulationsanwendung 18, in der die Simulationskomponenten 6 der Simulationskomponentenebene 12 einem Simulationsagententypen 16 mit den Laufzeitumgebungs-Informationsmodulen 8 der Simulationskomponenten 6 zugeordnet werden, wobei der Simulationsagententyp 16 eine Beschreibung der Eigenschaften des zur Ausführung des Simulationsmoduls 1 benötigten Simulationsagenten 4 ist,
S6a) Bereitstellen eines Simulationsagenteninventars, das die den Simulationsagententypen 16 entsprechenden Simulationsagenten 4 enthält, und
S6b) Assoziieren der Co-Simulationsanwendung 18 mit den Simulationsagenten 4.

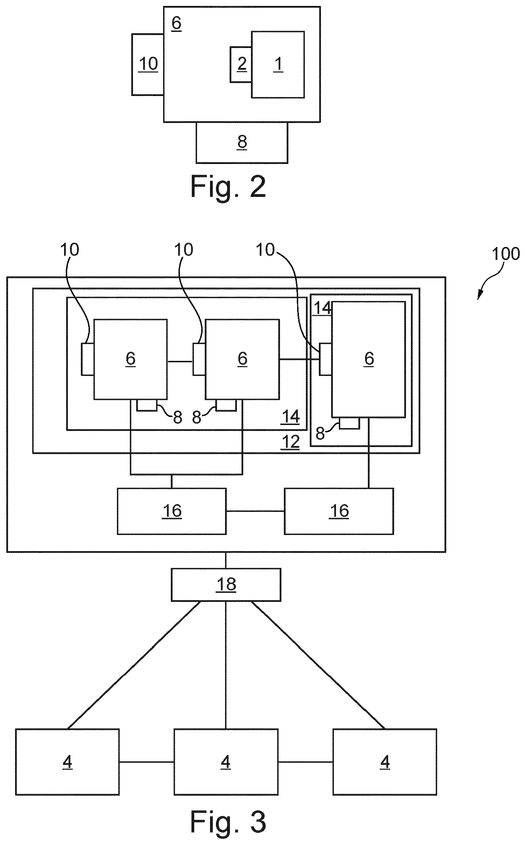

In Fig. 2 wird schematisch die erfindungsgemäße Simulationskomponente 6 gezeigt. Die Simulationskomponente 6 ist mit dem Laufzeitumgebungs-Informationsmodul 8 und der Kommunikationseinheit 10 ausgebildet. Die Kommunikationseinheit 10 enthält eine Beschreibung der in der Simulationskomponente 6 aufgenommenen Kommunikationsschnittstelle 2 des Simulationsmoduls 1. Das Simulationsmodul 1 kann ein Skript sein. Ein Skript ist eine Datei, die mit dem Simulationsagenten 4 umsetzbar ist und auch im Binärformat vorliegen kann. Sollte es notwendig sein, kann vor der Ausführung eine Executable aus dem Simulationsmodul 1 erzeugt werden.

Fig. 3 schließlich zeigt schematisch eine Co-Simulation 100 gemäß einem bevorzugten Ausführungsbeispiel der Erfindung. Die Simulationskomponenten 6 sind entsprechend ihrer Anforderungen an die Laufzeitumgebung in die Verarbeitungseinheitsanwendungen 14 eingeordnet. Die Kommunikationseinheiten 10 der Simulationskomponenten 6 sind miteinander verbunden und die Simulationskomponenten 6 bilden die Simulationskomponentenebene 12. Diese ist unabhängig von den physischen Anforderungen an die Laufzeitumgebung. Die Anforderungen zur Ausführung der Simulationskomponentenebene 12 mit den jeweiligen Simulationsagenten 4 sind jedoch in den Laufzeitumgebungs-Informationsmodulen 8 enthalten. In dem Simulationsinventar werden die in einem Simulationsagententypen-Netzwerk verfügbaren Simulationsagententypen 16 aufgeführt. Aus diesem Simulationsagententypen-Netzwerk werden dann die zur Ausführung der Co-Simulationsanwendung benötigten Simulationsagententypen 16 ausgewählt. Die Co-Simulationsanwendung 18 wird erstellt, in der die Simulationskomponenten 6 der Simulationskomponentenebene 12 einem Simulationsagententypen 16 mit den Laufzeitumgebungs-Informationsmodulen 8 der Simulationskomponenten 6 zugeordnet werden. Die den Simulationsagententypen 16 entsprechenden Simulationsagenten 4 sind in dem bereitgestellten Simulationsagenteninventar enthalten. Die Simulationsagenten 4 können so mit der Co-Simulationsanwendung 18 assoziiert werden. Die Simulationsagenten 4 sind netzwerktechnisch miteinander verbunden, sodass das Ausführen der in den Simulationskomponenten 6 enthaltenen Simulationsmodule 1 mit der durch das Bilden einer Co-Simulationsanwendung 18 erzeugten Hierarchie orchestrierbar ist. Darüber hinaus können Daten zwischen den Simulationsagenten 4 übertragen werden. Im Fall einer bedingten Co-Simulation 100 in der beispielsweise eine Workstation mit Hardware zum Betreiben dieser Hardware auf das Ergebnis einer vorangegangenen Simulation angewiesen ist, wird dieses zwischen den Simulationsagenten 4 übertragen.

### Bezugszeichenliste

- 1: Simulationsmodul
- 2: Kommunikationsschnittstelle
- 4: Simulationsagent
- 6: Simulationskomponente
- 8: Laufzeitumgebungs-Informationsmodul
- 10: Kommunikationseinheit
- 12: Simulationskomponentenebene
- 14: Verarbeitungseinheitsanwendung
- 16: Simulationsagententyp
- 18: Co-Simulationsanwendung
- 100: Co-Simulation

## Patentansprüche

1. Computerimplementiertes Verfahren zum Erstellen einer eine Mehrzahl von Simulationsmodulen (1) aufweisenden Co-Simulation (100), wobei die Simulationsmodule (1) jeweils wenigstens eine Kommunikationsschnittstellen (2) aufweisen und jeweils mit Simulationsagenten (4) ausführbar sind, umfassend die folgenden Verfahrensschritte:
S1) Erzeugen von Simulationskomponenten (6), die jeweils ein Container für ein Simulationsmodul oder mehrere Simulationsmodule sind,
S2) Einordnen der Simulationsmodule (1) in die Simulationskomponenten (6),
S3) Versehen jeder Simulationskomponente (6) mit einem Laufzeitumgebungs-Informationsmodul (8), das Informationen zu Anforderungen der in der Simulationskomponente (6) enthaltenen Simulationsmodule (1) an die Laufzeitumgebung aufweist, wobei die jeweiligen Simulationsagenten (4) den Anforderungen der Simulationsmodule (1) entsprechende Eigenschaften aufweisen müssen, um diese ausführen zu können,
S4) Versehen einer jeden Simulationskomponente (6) mit einer Kommunikationseinheit (10), die eine Beschreibung der Kommunikationsschnittstelle (2) des Simulationsmoduls (1) enthält, sodass eine Kommunikation mit weiteren Simulationskomponenten (6) ermöglicht wird,
S5) Verbinden der Kommunikationseinheiten (10) der Simulationskomponenten (6) mit einer oder mehreren Kommunikationseinheiten (10) weiterer Simulationskomponenten (6), sodass ein Netzwerk der über die Kommunikationseinheiten (10) miteinander verbundenen Simulationskomponenten (6) gebildet wird, wobei dieses Netzwerk aus Simulationskomponenten (6) eine Simulationskomponentenebene (12) bildet, die unabhängig von den physischen Anforderungen an die Laufzeitumgebung ist, die Informationen zu den Anforderungen zur Ausführung der Simulationskomponentenebene (12) jedoch in den Laufzeitumgebungs-Informationsmodulen (8) enthalten sind, und
S5a) Gruppieren von Simulationskomponenten (6) mit kompatible Anforderungen aufweisenden Laufzeitumgebungs-Informationsmodulen (8) und
S5b) Kategorisieren der Simulationskomponenten (6) mit kompatible Anforderungen aufweisenden Laufzeitumgebungs-Informationsmodulen (8) in eine Verarbeitungseinheitsanwendung (14), sodass Simulationskomponenten (6) mit kompatible Anforderungen aufweisenden Laufzeitumgebungs-Informationsmodulen (8) in einer gemeinsamen Verarbeitungseinheitsanwendung (14) angeordnet sind und Simulationskomponenten (6) mit zueinander inkompatible Anforderungen aufweisenden Laufzeitumgebungs-Informationsmodulen (8) in verschiedenen Verarbeitungseinheitsanwendung (14) angeordnet sind,
S5c) Bilden eines Simulationsinventars, das die in einem Simulationsagententypen-Netzwerk verfügbaren Simulationsagententypen (16) enthält, und
S5d) Auswählen der für die Ausführung der Verarbeitungseinheitsanwendung (14) benötigten Simulationsagententypen (16) aus dem Simulationsinventar,
S6) Erstellen einer Co-Simulationsanwendung (18), in der die Simulationskomponenten (6) der Simulationskomponentenebene (12) einem Simulationsagententypen (16) mit den Laufzeitumgebungs-Informationsmodulen (8) der Simulationskomponenten (6) zugeordnet werden, wobei der Simulationsagententyp (16) eine Beschreibung der Eigenschaften des zur Ausführung des Simulationsmoduls (1) benötigten Simulationsagenten (4) ist und
S6a) Bereitstellen des Simulationsagenteninventars, das die den Simulationsagententypen (16) entsprechenden Simulationsagenten (4) enthält, und
S6b) Assoziieren der Co-Simulationsanwendung (18) mit den Simulationsagenten (4).

2. Verfahren nach Anspruch 1, wobei die Simulationsagenten dazu eingerichtet sind, Hardware-in-the-loop, Software-in-the-loop- oder Model-in-the-loop-Simulationen ausführen zu können.

3. Verfahren nach einem der vorhergehenden Ansprüche, wobei die Co-Simulationsanwendung (18) auf einem Rechen-Cluster parallelisiert ausgeführt wird.

4. Verfahren nach Anspruch 3, wobei die Co-Simulationsanwendung (18) auf einer GPU-Architektur des Rechen-Clusters parallelisiert ausgeführt wird.

5. Verfahren nach einem der vorhergehenden Ansprüche, wobei mehrere Instanzen von der Co-Simulationsanwendung (18) erzeugt werden.

6. Verfahren nach eine der vorhergehenden Ansprüche, wobei die Simulationsagenten (4) Teil eines Cloud-Computing-Systems sind und die Co-Simulationsanwendung (18) auf dieses Cloud-Computing-System portiert wird.

7. Nichtflüchtiges, computerlesbares Speichermedium mit darauf abgespeicherten Befehlen, die bei ihrer Ausführung auf einem Prozessor ein Verfahren nach einem der vorhergehenden Ansprüche bewirken.

## Claims

1. A computer-implemented method for creating a co-simulation (100) comprising a plurality of simulation modules (1), wherein the simulation modules (1) each comprise at least one communication interface (2) and each can be executed with simulation agents (4), comprising the following method steps:
S1) Generating simulation components (6), each of which is a container for one or more simulation modules,
S2) Assigning the simulation modules (1) to the simulation components (6),
S3) Providing each simulation component (6) with a runtime environment information module (8), which contains information regarding the requirements of the simulation modules (1) contained in the simulation component (6) with respect to the runtime environment, wherein the respective simulation agents (4) must possess properties corresponding to the requirements of the simulation modules (1) in order to be able to execute them,
S4) Equipping each simulation component (6) with a communication unit (10) that contains a description of the communication interface (2) of the simulation module (1), thereby enabling communication with other simulation components (6),
S5) Connecting the communication units (10) of the simulation components (6) to one or more communication units (10) of other simulation components (6), thereby forming a network of simulation components (6) interconnected via the communication units (10), wherein this network of simulation components (6) forms a simulation component layer (12) that is independent of the physical requirements of the runtime environment, although information regarding the requirements for executing the simulation component layer (12) is contained in the runtime environment information modules (8), and
S5a) Grouping simulation components (6) with runtime environment information modules (8) that have compatible requirements, and
S5b) Categorizing the simulation components (6) with runtime environment information modules (8) having compatible requirements into a processing unit application (14), so that simulation components (6) with runtime environment information modules having compatible requirements (8) are arranged in a common processing unit application (14), and simulation components (6) with runtime environment information modules (8) having mutually incompatible requirements are arranged in different processing unit applications (14),
S5c) Forming a simulation inventory that contains the simulation agent types (16) available in a simulation agent type network, and
S5d) Selecting the simulation agent types (16) required for executing the processing unit application (14) from the simulation inventory,
S6) Creating a co-simulation application (18) in which the simulation components (6) of the simulation component layer (12) are assigned to a simulation agent type (16) with the runtime environment information modules (8) of the simulation components (6), wherein the simulation agent type (16) is a description of the properties of the simulation agent (4) required to execute the simulation module (1), and
S6a) Providing the simulation agent inventory, which contains the simulation agents (4) corresponding to the simulation agent types (16), and
S6b) Associating the co-simulation application (18) with the simulation agents (4).

2. The method according to claim 1, wherein the simulation agents are configured to perform hardware-in-the-loop, software-in-the-loop, or model-in-the-loop simulations.

3. A method according to any of the preceding claims, wherein the co-simulation application (18) is executed in parallel on a computing cluster.

4. The method according to claim 3, wherein the co-simulation application (18) is executed in parallel on a GPU architecture of the computing cluster.

5. The method according to any of the preceding claims, wherein multiple instances of the co-simulation application (18) are generated.

6. A method according to any of the preceding claims, wherein the simulation agents (4) are part of a cloud computing system and the co-simulation application (18) is ported to this cloud computing system.

7. A non-volatile, computer-readable storage medium having stored thereon instructions that, when executed on a processor, cause a method according to one of the preceding claims.

## Revendications

1. Procédé mis en œuvre par ordinateur pour créer une co-simulation (100) comportant une pluralité de modules de simulation (1), les modules de simulation (1) comportant chacun au moins une interface de communication (2) et pouvant chacun être exécutés avec des agents de simulation (4), comprenant les étapes suivantes :
S1) Génération de composants de simulation (6), qui constituent chacun un conteneur pour un ou plusieurs modules de simulation,
S2) Affectation des modules de simulation (1) aux composants de simulation (6),
S3) Doter chaque composant de simulation (6) d'un module d'informations sur l'environnement d'exécution (8), qui contient des informations sur les exigences des modules de simulation (1) contenus dans le composant de simulation (6) vis-à-vis de l'environnement d'exécution, les agents de simulation (4) respectifs devant présenter des propriétés correspondant aux exigences des modules de simulation (1) afin de pouvoir les exécuter,
S4) Doter chaque composant de simulation (6) d'une unité de communication (10) contenant une description de l'interface de communication (2) du module de simulation (1), de manière à permettre la communication avec d'autres composants de simulation (6),
S5) Relier les unités de communication (10) des composants de simulation (6) à une ou plusieurs unités de communication (10) d'autres composants de simulation (6), de manière à former un réseau de composants de simulation (6) interconnectés via les unités de communication (10), ce réseau de composants de simulation (6) forme un niveau de composants de simulation (12) qui est indépendant des exigences physiques imposées à l'environnement d'exécution, les informations relatives aux exigences pour l'exécution du niveau de composants de simulation (12) étant toutefois contenues dans les modules d'informations sur l'environnement d'exécution (8), et
S5a) Regroupement des composants de simulation (6) avec des modules d'informations sur l'environnement d'exécution (8) présentant des exigences compatibles, et
S5b) Classer les composants de simulation (6) associés à des modules d'informations sur l'environnement d'exécution (8) présentant des exigences compatibles dans une application d'unité de traitement (14), de sorte que les composants de simulation (6) associés à des modules d'informations sur l'environnement d'exécution présentant des exigences compatibles (8) soient regroupés dans une application d'unité de traitement commune (14) et que les composants de simulation (6) associés à des modules d'informations sur l'environnement d'exécution (8) présentant des exigences incompatibles entre elles soient répartis dans différentes applications d'unité de traitement (14),
S5c) Création d'un inventaire de simulation contenant les types d'agents de simulation (16) disponibles dans un réseau de types d'agents de simulation, et
S5d) Sélectionner, dans l'inventaire de simulation, les types d'agents de simulation (16) nécessaires à l'exécution de l'application d'unité de traitement (14),
S6) Création d'une application de co-simulation (18) dans laquelle les composants de simulation (6) du niveau des composants de simulation (12) sont associés à un type d'agent de simulation (16) avec les modules d'informations sur l'environnement d'exécution (8) des composants de simulation (6), le type d'agent de simulation (16) étant une description des propriétés de l'agent de simulation (4) nécessaire à l'exécution du module de simulation (1), et
S6a) Mise à disposition de l'inventaire d'agents de simulation, qui contient les agents de simulation (4) correspondant aux types d'agents de simulation (16), et
S6b) Association de l'application de co-simulation (18) aux agents de simulation (4).

2. Procédé selon la revendication 1, dans lequel les agents de simulation sont conçus pour pouvoir effectuer des simulations de type « hardware-in-the-loop », « software-in-the-loop » ou « model-in-the-loop ».

3. Procédé selon l'une des revendications précédentes, dans lequel l'application de co-simulation (18) est exécutée en parallèle sur un cluster de calcul.

4. Procédé selon la revendication 3, dans lequel l'application de co-simulation (18) est exécutée en parallèle sur une architecture GPU du cluster de calcul.

5. Procédé selon l'une des revendications précédentes, dans lequel plusieurs instances de l'application de co-simulation (18) sont générées.

6. Procédé selon l'une des revendications précédentes, dans lequel les agents de simulation (4) font partie d'un système de cloud computing et l'application de co-simulation (18) est portée sur ce système de cloud computing.

7. Support de stockage non volatile lisible par ordinateur, sur lequel sont stockées des instructions qui, lors de leur exécution sur un processeur, mettent en œuvre un procédé selon l'une des revendications précédentes.
